Europäisches Patentamt

European Patent Office

Office européen des brevets

(19)

(11) **EP 1 032 721 B1**

(12) **EUROPÄISCHE PATENTSCHRIFT**

(45) Veröffentlichungstag und Bekanntmachung des Hinweises auf die Patenterteilung:
**13.02.2002 Patentblatt 2002/07**

(21) Anmeldenummer: **98965076.7**

(22) Anmeldetag: **10.11.1998**

(51) Int Cl.⁷: **C23C 14/00**, C23C 28/00

(86) Internationale Anmeldenummer:
**PCT/DE98/03367**

(87) Internationale Veröffentlichungsnummer:
**WO 99/27147 (03.06.1999 Gazette 1999/22)**

(54) **VERSCHLEISSBESTÄNDIGER, MECHANISCH HOCHBELASTBARER UND REIBUNGSARMER RANDSCHICHTAUFBAU FÜR TITAN ODER SEINE LEGIERUNGEN SOWIE VERFAHREN ZU SEINER HERSTELLUNG**

WEAR-RESISTANT, MECHANICALLY HIGHLY STRESSED AND LOW-FRICTION BOUNDARY COATING CONSTRUCTION FOR TITANIUM OR THE ALLOYS THEREOF AND A METHOD FOR PRODUCING THE SAME

STRUCTURE COUCHE SUPERFICIELLE RESISTANTE A L'USURE, A HAUTE CAPACITE DE CHARGE MECANIQUE ET A FAIBLES FROTTEMENTS DESTINEE AU TITANE OU A SES ALLIAGES ET PROCEDE DE PRODUCTION CORRESPONDANT

(84) Benannte Vertragsstaaten:
**CH DE GB LI SE**

(30) Priorität: **19.11.1997 DE 19751337**

(43) Veröffentlichungstag der Anmeldung:
**06.09.2000 Patentblatt 2000/36**

(73) Patentinhaber: **FRAUNHOFER-GESELLSCHAFT ZUR FÖRDERUNG DER ANGEWANDTEN FORSCHUNG E.V.**
**80636 München (DE)**

(72) Erfinder:
• **BRENNER, Berndt**
**D-01474 Pappritz (DE)**
• **BONSS, Steffen**
**D-98544 Zella-Mehlis (DE)**
• **SCHEIBE, Hans-Joachim**
**D-01309 Dresden (DE)**
• **ZIEGELE, Holger**
**80992 München (DE)**

(56) Entgegenhaltungen:
**EP-A- 0 322 812**      **EP-A- 0 401 488**
**EP-A- 0 491 075**      **DE-C- 19 637 450**
**GB-A- 2 282 149**      **US-A- 5 290 368**

**Beschreibung**

Die Erfindung bezieht sich auf die Randschichtveredlung von Funktionsbauteilen. Objekte, bei denen ihre Anwendung möglich und zweckmäßig ist, sind alle gleitverschleißbeanspruchten Funktionsbauteile aus Titan oder seinen Legierungen, die bei Einsatztemperaturen unter 500 °C belastet werden, einer hohen Flächenpressung unterworfen sind und einen möglichst geringen Reibungskoeffizienten aufweisen müssen. Besonders vorteilhaft ist die Erfindung zum Schutz von Humanimplantaten, insbesondere mit oszillierenden Bewegungsabläufen sowie gleitverschleißbeanspruchten Bauteilen aus dem Luft- und Raumfahrtsektor einsetzbar.

Titan ist ein hervorragender Konstruktionswerkstoff, dessen hohe spezifische Festigkeit, chemische Beständigkeit und Biokompatibilität ihn für verschiedene Sonderanwendungen prädestiniert. Einer größeren Einsatzbreite steht jedoch vielfach seine geringe Beständigkeit gegenüber Gleitverschleiß und sein hoher Reibungskoeffizient entgegen.

Es ist bekannt, sehr verschleißbeständige Randschichten auf Titan durch Lasergaslegieren zu erzeugen (vgl. z.B. H.W. Bergmann: "Thermochemische Behandlung von Titan und Titanlegierungen durch Laserumschmelzen und Gaslegieren", Zeitschrift für Werkstofftechnik 16 (1985), S. 392, 405).

Darüber hinaus ist bekannt, das Lasergaslegieren zum Schutz von Gelenkendoprothesen zu verwenden (PS DE 3 917 211). Dazu wird das Bauteil durch den Laserstrahl bis auf eine Tiefe von 0,1 bis 0,7 mm aufgeschmolzen und gleichzeitig Stickstoff in die Schmelze eingeblasen. Wegen der hohen Affinität des Titans zu reaktiven Gasen bildet sich sofort Titannitrid, das sich in Form von Nadeln aus der Schmelze ausscheidet. Nach der Erstarrung besteht die Randschicht aus einer metallischen Matrix aus Titan mit einem gegenüber dem Ausgangszustand veränderten $\alpha/\beta$-Anteil sowie sehr dicht eingelagerten teilweise recht groben Titannitrid-Nadeln. Die Härte der Randschicht beträgt üblicherweise bis 1.000 HV.

Der Mangel solcher Schichten besteht jedoch darin, dass sie einen großen Reibungskoeffizient aufweisen und darüber hinaus einen starken Abrieb bei den meisten verwendbaren Gegenkörpern hinterlassen. Die Ursache dieses Mangels besteht darin, dass die sehr harten Titannitrid-Nadeln nach dem Einlaufverschleiß aus der Oberfläche hervorragen. Dadurch wird die lokale Beanspruchung des Tribosystems bis zur Furchung des Gegenkörpers erhöht und gleichzeitig mikroskopische Verhakungen der Titannitrid-Nadeln mit dem Gegenkörper bewirkt, die den Reibungskoeffizient erhöhen.

Ein weiterer Mangel dieser Schichten tritt unter Belastung in einer sauerstoffhaltigen Atmosphäre und bevorzugt unter höheren Temperaturen auf und äußert sich darin, dass es besonders unter Mangelschmierbedingungen zu einem katastrophalen Versagen der Reibpaarung kommen kann. Die Ursache hierfür besteht darin, dass die metallische Matrix zwischen den TiN-Nadeln eine hohe Affinität zum Sauerstoff hat.

Um die negativen Auswirkungen der TiN-Nadeln, insbesondere für den Anwendungsbereich der Humanimplantate, umgehen zu können, ist ein Verfahren zum Gasnitrieren (PS US 5,326,362) bekannt geworden, bei dem molekularer Stickstoff bei einer Prozesstemperatur von 400 °C bis 704,4 °C in die oberflächennahen Bereiche eindiffundiert und durch eine Lösungshärtung eine verschleißfeste Randschicht bildet. Dazu wird das Bauteil in einem Vakuumofen plaziert, auf einen Druck von 133,32•10$^{-6}$ Pa evakuiert, anschließend mit 1 at Stickstoff aufgefüllt, auf 537,7 °C aufgeheizt, der Stickstoffdruck auf 2 at erhöht und mehrere Stunden bei 593,3 °C nitriert. Nach Abschluss der Behandlung besteht die Randschicht aus einer 0,2 µm dicken Verbindungsschicht aus Titannitriden, Titancarbonitiriden, Titanoxiden und -carbooxiden und einer einige µm dicken Diffusionsschicht. Die sich in der Verbindungsschicht befindlichen Titannitride sind bedeutend feindisperser als beim Lasergaslegieren. Da die Verbindungsschicht eine geschlossene Schicht auf der Oberfläche bildet, wird damit gleichzeitig die Belastunsfähigkeit der Schicht unter sauerstoffhaltiger Atmosphäre und erhöhten Temperaturen verstärkt.

Die Mängel dieses Verfahrens bestehen jedoch darin, dass der Gleitreibungskoeffizient nicht ausreichend herabgesetzt wird und dass die Verschleißbeständigkeit bei hohen Kontaktdrücken nicht ausreichend ist. Die Ursache dieser Mängel resultiert daraus, daß einerseits die Verbindungsschicht weiterhin aus sehr harten und nicht völlig ebenen Titannitrid-Nadeln besteht, die den Gegenkörper furchen und andererseits die darunterliegende Diffusionsschicht zu dünn ist, um einer hohen lokalen Belastung ausreichend lange widerstehen zu können. Letzteres resultiert in erster Linie daraus, daß bei einer Hertz'schen Pressung mit den in der Praxis auftretenden Kontaktflächen das Spannungsmaximum unter der Schicht liegt. Im weichen Grundmaterial kann es deshalb zu plastischen Deformationen kommen, die zu einem Abheben der spröden Verbindungsschicht führen.

Ziel der Erfindung ist es, einen vor Gleitverschleiß deutlich beständigeren, biokompatiblen Randschichtaufbau mit sehr geringen Gleitreibungskoeffizienten für Titan und seine Legierungen anzugeben und ein Verfahren zu seiner Herstellung vorzuschlagen.

Der Erfindung liegt die Aufgabe zu Grunde, einen Randschichtaufbau anzugeben, der unter Nutzung der hohen Verschleißbeständigkeit des Titannitrids eine um mindestens eine Größenordnung höhere Einhärtetiefe aufweist und der direkt in der Oberfläche keine Titannitrid-Nadeln enthält.

Erfindungsgemäß wird diese Aufgabe mit einem verschleißbeständigen, mechanisch hochbelastbaren und reibungsarmen Randschichtaufbau für Titan oder seine Legierungen, bestehend aus einer lasergaslegierten Schicht mit ausgeschiedenen Titannitridnadeln, wie in mindestens einem der Ansprüche 1 bis 3 ausgeführt, gelöst.

Bei der erfindungsgemäßen Lösung kommt der extrem dünnen (5 - 50 nm, im Anwendungsfall einer Endrauhigkeit vor Schichtabscheidung < 0,10 μm vorzugsweise im Bereich zwischen 5 - 20 nm) Zwischenschicht insbesondere aus ökonmischer Sicht (sehr kurze Prozeßzeiten) und aufgrund der Tatsache, daß bei diesen geringen Zwischenschichtdicken besonders hohe Haftfestikeiten der hart-amorphen Kohlenstoffschicht erreicht werden können, eine besondere Bedeutung zu.

Anspruch 2 stellt eine vorteilhafte Ausgestaltung der Zwischenschicht dar, bei der eine besonders gute Haftung der hart-amorphen Kohlenstoffschicht erreicht wird.

Außerdem wird die Aufgabe durch ein Verfahren zur Erzeugung eines Randschichtaufbaues mit niedrigen Reibungskoeffizienten und einer sehr hohen Lasttragfähigkeit gelöst. Erfindungsgemäß wird dabei wie in Anspruch 4 angegeben, vorgegangen.

Die Erfindung ist an nachfolgenden Ausführungsbeispielen näher erläutert.

In den dazugehörigen Zeichnungen sind der erfindungsmäßige Schichtaufbau (Zeichnung 1) sowie die Verbesserung des Verschleißverhaltens (Zeichnung 2 a) und des Reibungsverhaltens (Zeichnung 2 b) dargestellt.

**Beispiel 1:**

Ein Bauteil (1) aus der Legierung Ti6Al4V mit den Abmaßen 10 x 40 x 60 mm$^3$ soll an einer Flachseite mit einem sehr verschleißbeständigen und reibungsarmen Schichtaufbau versehen werden.

Dazu wird das geschliffene und mit einem Lösungsmittel von Fettrückständen gereinigte Bauteil auf dem Bearbeitungstisch einer CNC-Maschine positioniert. Über dem Bauteil befindet sich eine spezielle Schutzgasglocke, in die ein in einer Gasmischstation eingestelltes $N_2$ - Ar-Gemisch bei Luftdruck im Verhältnis $N_2$ : Ar = 60 : 40 bzw. $N_2$ : Ar = 70 : 30 eingeblasen wird. Die Schutzglocke ist so konstruiert, dass sie in drei Koordinateneinrichtungen frei beweglich ist und schon nach einer Spülzeit von 90 s einen Sauerstoffrestgehalt ≤ 3 ppm garantiert. Die Laserleistung beträgt 5 kW, der Strahl hat auf dem Bauteil einen Durchmesser von 3,4 mm, als Vorschubgeschwindigkeit wird 8 mm/s gewählt. Der Spurabstand beträgt 0,75 mm bei einer sich ergebenden Spurbreite von 4,5 mm. Daraus ergibt sich ein Überlappungsgrad von 83,3%. Nach Erreichen des Sauerstoffpartialdruckes < 5 ppm wird der Prozess des Gaslegierens durch den Start des CNC-Programms und die Laserstrahlfreigabe gestartet. Die so erzeugte Schicht ist 1,2 mm tief, besteht aus Titannitridnadeln, die in einer Titanmatrix eingebettet sind.

Nach Erkalten des Bauteiles (1) wird dessen Oberfläche mit einer diamantgebundenen Schleifscheibe der Körnung 125 μm geschliffen, bis eine gleichmäßige Oberfläche mit einer Rauhigkeit ≤ 0,62 μm erreicht ist. Danach erfolgt das Schleifen mit SiC-Papier P800 bis P1200, bis eine Rauhigkeit von ≤ 0,12 μm erreicht ist.

Anschließend wird die Oberfläche des Bauteiles (1) in einer Vakuumkammer durch Ionenbeschuss mit Argon-Ionen gereinigt. In der gleichen Kammer befindet sich eine Anordnung zur Durchführung des lasergesteuerten, gepulsten Vakuumbogen (Laser-Arc) - Prozesses zur Erzeugung der hart-amorphen Kohlenstoffschichten. Die Anordnung besteht aus einem gepulsten Vakuumbogen, dem als Kathode geschalteten Targetmaterial sowie einem gütegeschalteten Nd-Yag-Laser mit einer Leistungsdichte >5 • $10^8$ W/cm$^2$. Das Bauteil (1) ist in einem Substrathalter befestigt.

Die walzenförmige Kathode ist zweigeteilt und besteht aus einer Titan- und einer Graphitwalze.

Zwischen Kathode und Anode wird eine Spannung angelegt, die noch nicht zur Zündung einer Bogenentladung ausreicht. Der Laser wird auf die Titanwalze fokussiert und angeschaltet. Seine Pulse erzeugen Plasmawolken, die jeweils eine kurze Bogenentladung zünden. Auf dem Substrat werden Ti-Ionen und -Atome abgeschieden. Nach Erreichen der erwünschten Schichtdicke der Zwischenschicht (3) wird auf die Graphit-Kathode umgeschaltet und die hart-amorphe Kohlenstoffschicht (4) auf dem Bauteil (1) abgeschieden. Die abgeschiedene Schicht ist 400 nm dick und besteht aus einem hart-amorphen Kohlenstofffilm.

Zur Bestimmung des Verschleißwiderstandes werden die Bauteile auf einem Kugel-Scheibe-Tribometer getestet, wobei die Kugel aus Hartmetall besteht.

Die Kugel hat einen Durchmesser von 3 mm und wird mit einer Kraft von 2,5 N auf die Probe gedrückt. Der Versuch wird unter Atmosphärenbedingungen bei Zimmertemperatur und ohne Schmiermittel durchgeführt. Der Verschleißabtrag wird mit einem Profilometer gemessen. Zu diesem Zweck wird der Versuch nach jeweils 30 m Verschleißweg unterbrochen. Der Gesamtverschleißweg beträgt 300 m.

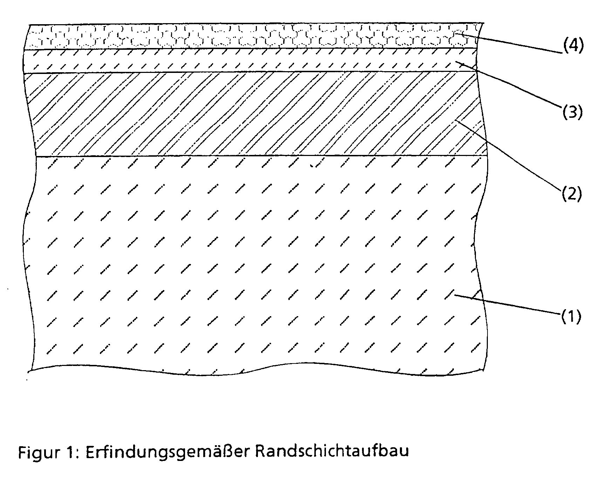

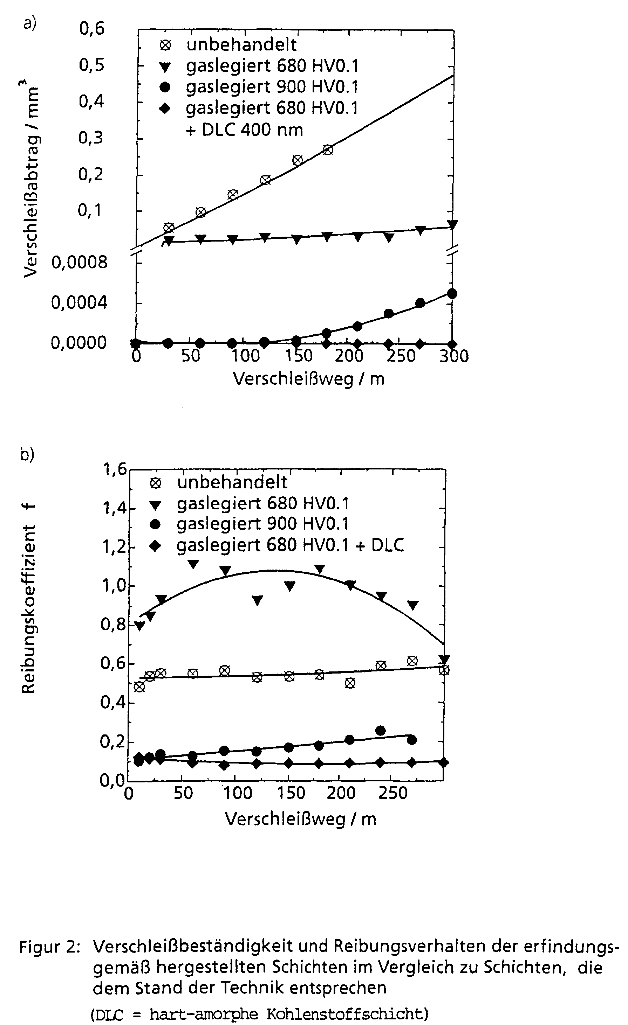

Fig. 2 a zeigt den Vergleich der Verschleißabträge der unbehandelten Titanlegierung, verschiedener nach dem Stand der Technik bekannter lasergaslegierter Schichten sowie den des erfindungsgemäßen Schichtaufbaues. Es ist deutlich, dass die Proben mit dem erfindungsgemäßen Schichtaufbau ein entscheidend besseres Verschleißverhalten aufweisen. Fig. 2 b zeigt den Einfluss des Randschichtveredlungsverfahrens auf den Reibungskoeffizienten der gleichen Behandlungsvarianten. Auch hier zeigt sich, dass der erfindungsgemäße Schichtaufbau entscheidend besser ist als die bekannten Verfahren.

**Beispiel 2:**

Mit analogem Versuchsaufbau und analoger Versuchsdurchführung wie in Beispiel 1 soll ein gekrümmtes Bauteil aus der Legierung Ti6Al4V mit den Abmaßen 6 x 40 x 16 mm³ an seiner gekrümmten Außenseite mit einem sehr verschleißbeständigen und reibungsarmen Schichtaufbau versehen werden.

Im Unterschied zu Beispiel 1 wird im Beispiel 2 jedoch nach der zweiten Schleifstufe noch ein Poliervorgang auf eine Endrauhigkeit < 0,10 μm durchgeführt.

Die Durchführung des Beschichtungsvorganges [Abscheidung der Zwischenschicht (3) und Abscheidung der hart-amorphen Kohlenstoffschicht (DLC-Schicht) (4)] erfolgt annalog Beispiel 1.

Nach Beendigung der Abscheidung wurde am beschichteten gekrümmten Bauteil unmittelbar auf der Bauteiloberfläche eine 10 nm dicke Ti-Zwischenschicht (3) und unmittelbar daran anschließend eine 300 nm hart-amorphe Kohlenstoff-Schicht (4) (DLC-Schicht) gemessen.

Darüberhinaus wurde für die verschleißfeste Schicht mittels Schwingverschleißtribometer bei den Versuchskenndaten

- Einsatz einer Kugel aus 100 Cr6 mit einem Durchmesser von 10 mm
- Hublänge 0,2 mm
- Belastung 10 N
- Schwingungsfrequenz f = 20 Hz
- Messung nach 100 000 Zyklen

ein Reibungskoeffizient von 0,1 und eine Verschleißtiefe von 50 nm ermittelt.

## Patentansprüche

1. Verschleißbeständiger, hochbelastbarer und reibungsarmer Randschichtaufbau auf Titansubstraten und dessen Legierungen aus einer lasergaslegierten Schicht mit ausgeschiedenen Titannitrid-Nadeln, **dadurch gekennzeichnet, dass** die Randschicht aus

   - einer 200 bis 400 nm dicken hart-amorphen Kohlenstoffschicht (4)
   - einer 5 bis 50 nm dicken Zwischenschicht (3)
   - und einer 0,3 bis 2,0 mm dicken lasergaslegierten Schicht (2) besteht

   und die gaslegierte Schicht eine Härte zwischen 600 $HV_{0,1}$ und 1400 $HV_{0,1}$ aufweist.

2. Randschichtaufbau nach Anspruch 1, **dadurch gekennzeichnet, dass** für den Anwendungsfall einer Endrauhigkeit vor Schichtabscheidung < 0,10 μm die Dicke der Zwischenschicht im Bereich zwischen 5 bis 20 nm liegt.

3. Randschichtaufbau nach Anspruch 1 oder 2, **dadurch gekennzeichnet, dass** die Zwischenschicht aus Titan besteht.

4. Verfahren zur Herstellung eines verschleißbeständigen, hochbelastbaren und reibungsarmen Randschichtaufbaues auf Titansubstraten und dessen Legierungen nach einem oder mehreren der Ansprüche von 1 bis 3, **dadurch gekennzeichnet, dass**

   **a.** die zu schützende Bauteiloberfläche spurweise mit einem Hochleistungslaser aufgeschmolzen wird,
   **b.** die Leistungsdichte p des Laserstrahles $1 \cdot 10^4$ W/cm² $\leq p \leq 2 \cdot 10^5$ W/cm² beträgt,
   **c.** das Aufschmelzen bei einem Sauerstoffpartialdruck < 5 ppm passiert,
   **d.** die reaktive Atmosphäre aus $N_2$ und Ar besteht, wobei ein relativer Stickstoffgehalt zwischen 40 % und 80 % gewählt wird,
   **e.** ein Überlappungsgrad Ü; Ü = $\frac{a - c}{a}$ ausgedrückt im Verhältnis (Spurbreite a - Spurabstand c): Spurbreite a von $0{,}5 \leq Ü \leq 0{,}9$ gewählt wird,
   **f.** das Bauteil anschließend bis mindestens zu einer Oberflächenrauhigkeit $\leq 0{,}2$ μm geschliffen wird,
   **g.** in einer Hochvakuumeinrichtung durch lonenbeschuss gereinigt wird,
   **h.** anschließend mit dem lasergesteuerten, gepulsten Vakuumbogen (Laser-Arc) - Verfahren die Zwischenschicht aufgebracht wird,
   **i.** und abschließend in der gleichen Anordnung mit dem lasergesteuerten, gepulsten Vakuumbogen (Laser-Arc)-Verfahren eine hart-amorphe Kohlenstoffschicht auf dem Bauteil abgeschieden wird.

## Claims

1. Wear-resistant, heavy-duty and low-friction boundary coating construction on titanium substrates and the alloys thereof made of a laser gas alloyed layer with precipitated titanium nitride needles, **characterised in that** the boundary coating comprises

   - a 200 to 400 nm thick hard amorphous carbon layer (4)
   - a 5 to 50 nm thick intermediate layer (3)
   - and a 0.3 to 2.0 mm thick laser gas alloyed layer (2)

   and the gas alloyed layer has a hardness between 600 $HV_{0.1}$ and 1400 $HV_{0.1}$.

2. Boundary coating construction according to claim 1, **characterised in that** the thickness of the intermediate layer is in the range between 5 to 20 nm for the application case of a final roughness before layer deposition < 0.10 μm.

**3.** Boundary coating construction according to claim 1 or 2, **characterised in that** the intermediate layer is made of titanium.

**4.** Method for production of a wear-resistant, heavy-duty and low-friction boundary coating construction on titanium substrates and the alloys thereof according to one or more of the claims from 1 to 3, **characterised in that**

   **a.** the component surface to be protected is melted as a track by a high power laser,
   **b.** the power density p of the laser beam is 1 x $10^4$ W/cm$^2$ ≤ p ≤ 2 x $10^5$ W/cm$^2$,
   **c.** melting takes place at an oxygen partial pressure < 5 ppm,
   **d.** the reactive atmosphere comprises $N_2$ and Ar, a relative nitrogen content between 40 % and 80 % being chosen,
   **e.** an overlapping degree O ; O = $\frac{a-c}{a}$ expressed as the ratio (track width a - track spacing c) : track width a being chosen from $0.5 \leq 0 \leq 0.9$.
   **f.** the component is next ground to at least a surface roughness ≤ 0.2 μm,
   **g.** it is cleaned in a high vacuum device by means of ion bombardment,
   **h.** the intermediate layer is next deposited by the laser-controlled, pulsed vacuum arc (laser arc) method,
   **i.** and finally a hard amorphous carbon layer is deposited on the component in the same arrangement by the laser-controlled, pulsed vacuum arc (laser arc) method.

**Revendications**

**1.** Structure de couche superficielle résistante à l'usure, à haute capacité de charge mécanique et à faibles frottements, sur des substrats au titane et ses alliages, à base d'une couche alliée au gaz laser avec des aiguilles de nitrure de titane déposées, **caractérisée en ce que** la couche superficielle consiste en

- une couche de carbone (4) dure, amorphe, de 200 à 400 nm d'épaisseur,
- une couche intermédiaire (3) de 5 à 50 nm d'épaisseur,
- une couche alliée au gaz laser (2) de 0,3 à 2,0 mm d'épaisseur,

et la couche alliée par les gaz possède une dureté comprise entre 600 HV$_{0,1}$ et 1400 HV$_{0,1}$.

**2.** Structure de couche superficielle selon la revendication 1, **caractérisée en ce que** pour le cas d'application d'une rugosité finale de dépôt de couche < 0,10 μm, l'épaisseur de la couche intermédiaire se situe dans la plage comprise entre 5 et 20 nm.

**3.** Structure de couche superficielle selon la revendication 1 ou 2, **caractérisée en ce que** la couche intermédiaire consiste en du titane.

**4.** Procédé de production d'une structure de couche superficielle résistante à l'usure, à haute capacité de charge mécanique, et à faibles frottements sur des substrats en titane ou ses alliages selon l'une ou plusieurs des revendications 1 à 3, **caractérisé en ce que**

   a) la surface de l'élément de construction à protéger est mise en fusion par stries avec un laser haute puissance,
   b) la densité de puissance p du rayon laser s'élève à 1 x $10^4$ W/cm$^2$ ≤ p ≤ 2.10$^5$ W/cm$^2$,
   c) la mise en fusion a lieu à une pression partielle d'oxygène < 5 ppm,
   d) l'atmosphère réactive consiste en $N_2$ et Ar, pour laquelle une teneur relative en azote est choisie entre 40 % et 80 %,
   e) un degré de chevauchement Ü = U $\frac{a-c}{a}$ exprimé dans le rapport (largeur de strie a - intervalle de strie c) : (largeur de strie a), de $0,5 \leq Ü \leq 0,9$ est choisi,
   f) la pièce est ensuite polie jusqu'à au moins une rugosité de surface de ≤ 0,2 μm, et
   g) est purifiée dans un dispositif à vide élevé par bombardement ionique,
   h) ensuite la couche intermédiaire est appliquée avec le procédé de l'arc sous vide (Arc-laser) pulsé, commandé par un laser,
   i) et ensuite dans la même disposition, on dépose sur la pièce avec le procédé de l'arc sous vide (Arc laser) pulsé commandé par laser, une couche de carbone amorphe, dure.

Figur 1: Erfindungsgemäßer Randschichtaufbau

Figur 2: Verschleißbeständigkeit und Reibungsverhalten der erfindungsgemäß hergestellten Schichten im Vergleich zu Schichten, die
dem Stand der Technik entsprechen

(DLC = hart-amorphe Kohlenstoffschicht)